# EUROPEAN PATENT SPECIFICATION

(11) **EP 1 234 189 B1**
(45) Date of publication and mention of the grant of the patent: **21.07.2004**
(21) Application number: 99952755.9
(22) Date of filing: 15.11.1999
(51) Int. Cl.: G01R 31/311

(54) **MULTI-LAYERED ELECTRONIC PARTS**
MEHRSCHICHTIGE ELEKTRONISCHE BAUTEILE
PIECES ELECTRONIQUES MULTICOUCHES

(43) Date of publication of application: 28.08.2002
(73) Proprietor: BELTRONICS, INC., Newton, MA 02159 (US)
(72) Inventor: BISHOP, Robert, Newton, MA 02159 (US)
(74) Representative: Warren, Anthony Robert
(86) International application number: PCT/IB1999/001830
(87) International publication number: WO 2000/046608

(56) References cited:
- EP-A- 0 438 882
- EP-A- 0 493 657
- US-A- 4 845 425

## Description

The present invention relates to the optical inspection of electronic parts and the like, being more particularly directed to multi-layered electronic parts such as those used for wafers from which integrated circuit chips are formed, flat display panels, multi-chip modules, and flexible circuit patches and decals, etc, wherein there are top layers of conductors in various patterns, an intermediate layer (sometimes externally carrying the conductor layer on top) and comprising transparent or translucent insulation, and base substrate or bottom layers as of ceramic, glass, metal and the like, also often carrying conductors in various patterns.

Fluorescent light emissions have previously been used to inspect electronic circuit boards consisting of layers of epoxy containing conductors defining circuits deposited therein. The conductors are generally metal that can have a very rough finish, such as copper, oxidized copper, reflowed copper with a tin covering and the like, wherein the rough surfaces prove too difficult properly to inspect for defects using optical imaging techniques. As a result, manufacturers of inspection equipment have employed lasers of wavelength suitable selectively to fluoresce the epoxy layer carrying the conductors comprising the electronic circuit. In doing this, the epoxy background fluoresces in a different wavelength (color) while the conductors do not fluoresce and thus appear dark. If the conductors have defects such as broken conductors, such defects will accordingly appear as non-dark areas and can be located. Likewise, shorts appear dark where a bright region should be, and are thereby detected as defects. The importance for this use of the fluorescence is specifically to overcome the effects of the optical variations or imaging imperfections in the rough conductor lines themselves.

In an article entitled "Digital Optical Imaging Of Benzo-Cydobritene (BCB) Thin Films On Silicon Wafers", by R.A. DeVries et al, Mat. Resi. Soc. Symp Proc. Vol 381, 1995, pages 165-173, thin films have been fluoresced to reveal thickness variations or particles and the like.

Fluorescence has also been used to detect various cracks and imperfections in machine parts and the like, wherein fluorescent material is washed on the part and then wiped off, so that the only place that the fluorescent material remains is in a crack or defect into which the fluorescent material has seeped.

In connection with the dense multi-layer integrated circuit parts of concern in connection with the present invention, on the other hand, where several layers or coatings are superimposed upon a bottom base substrate layer that itself may contain conductor lines and upon which a transparent or translucent intermediate insulation layer is superposed, in turn carrying a top layer containing patters of conductors to be inspected for defects, a very different problem arises in the optical inspecting of such multi-layered parts for such defects and the like. This problem resides from the compounding of reflections from all the superposed layers since the reflected incident light reflects from the lower layers as well as the top layer, creating an overlay of all these reflections which does not allow discriminating inspection of just the top conductor pattern layer alone, as required.

Attempts to discriminate the top conductor pattern images by the use of dark fields, shallow angle illumination, color discrimination, and cross polarization illumination have not met with success.

Underlying the present invention, however is the discovery that through the use of an intermediate light transmitting preferably translucent or transparent insulating layer that is susceptible, in response to a predetermined wavelength of incident light, to fluorescing at a different wavelength, the conductors of the conductor pattern on the top layer reflect the incident light at its original wavelength and do not fluoresce, and can be readily distinguished, and the desired inspection of the top layer conductors only can be discriminatingly and selectively achieved, while also rejecting, masking or making disappear, any incident light reflections from layers below the intermediate fluorescing layer, admirably solving the above-mentioned problem.

While such an approach has been taken with carefully pre-machined flat layered surfaces in the prior art, such is not adapted for the irregular bumpy boards and angled conductors of mass produced circuit boards and wafers and the like, addressed by the present invention.

It is an object of the present invention to provide a new and improved method and apparatus which use the latter approach, and are suitable for inspecting an electronic part having an irregular bumpy intermediate layer on which are deposited correspondingly angled conductors to be inspected.

According to one aspect of the present invention, there is provided a method for optically inspecting a multi-layered electronic part as defined in claim 1.

According to another aspect of the invention, there is provided apparatus for optically inspecting a multi-layered electronic part as defined in claim 8.

One embodiment of the present invention will now be described in connection with the accompanying drawings, in which:-
Figs. 1A and 1B are partial cross sectional views showing light reflection from a multi-layer chip or the like back to a camera in accordance with the techniques embodying the present invention, the chip in Fig. 1B having been moved in scanning to the left, in front of the camera from the position of Fig. 1A;
Fig. 1C is a similar view at a next scanning position showing fluorescent scatter back to the camera from the intermediate layer only;
Fig. 2 is a graph illustrating a preferred fluorescent spectrum range from preferred intermediate layer insulation material in response to Argon incedent light of emission line 488 nanometers;
Fig. 3 is a view of the overlaying intermingled and indistinguishable reflections occurring from various layers of a multi-layer wafer prior to the present invention and which render the discriminating detection of defects in just the top layer substantially impossible;
Fig. 4 is a view of the imaging achieved by the method and apparatus embodying the invention, showing a total solution to the problem of selectively indicating the top layer pattern of conductors and suppressing all reflections below the intermediate layer; and
Figs. 5 and 6 are respectively views similar to Figs. 3 and 4 for a different wafer, again showing the efficacy of the invention.

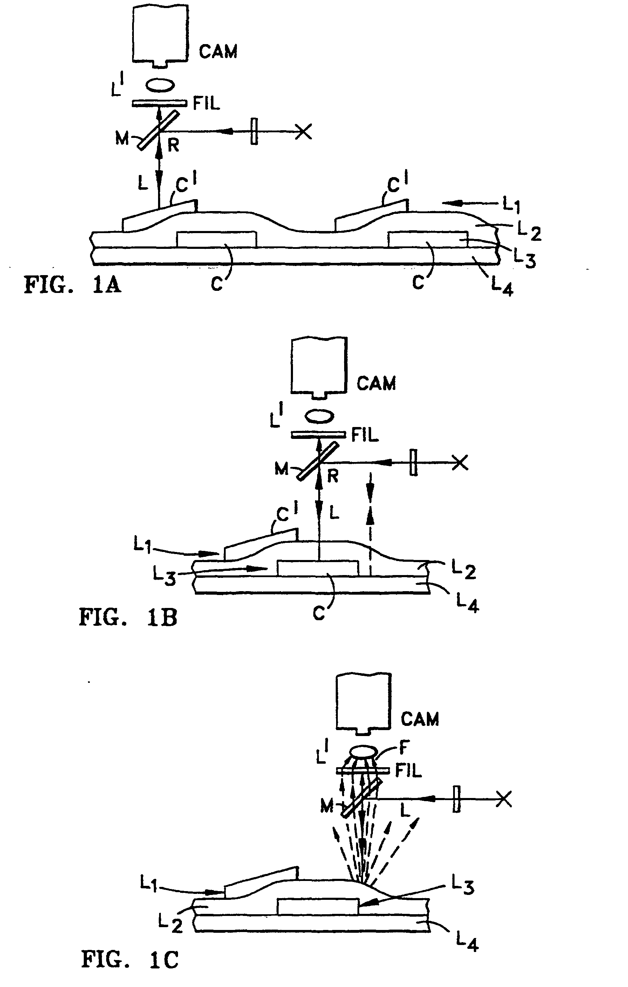

A typical multi-layer chip of the character above-described is shown in Figs. 1A - C, comprising a base or substrate layer L₄ as of ceramic, for example, shown carrying a layer L₃ of metal conductors C thereupon, and in turn covered by an intermediate layer L₂, generally preferably translucent or transparent as, for example, of organic polyimide material and the like, which insulates the lower layer conductors C from further conductors C¹ on a top layer L₁ superposed upon the intermediate insulating layer L₂.

Incident light L from a light source is illustrated as directed by a half-silvered mirror M upon the top layer L₁ of the chip and reflects from the top layer pattern of conductors C¹. The solid vertical arrowed lines indicate light-illuminating incidence L and rejection R back towards the inspection camera CAM. Since the intermediate insulation layer L₂ covering the lower conductors C of the layer L₃ will not be flat, but irregular with bumps, as shown, formed by depressions in the layers, the top conductors C¹ may be somewhat angled by the projecting irregularities or bumps in layer L₂, as shown, and some reflection therefrom will not reach the camera in view of the angle of the deposited layer of conductor C¹; but flat regions of the conductor C¹ will reflect light back at R up toward the inspection camera. In view of the light transmitting properties of the translucent or transparent intermediate insulation layer L₂, light will also reflect back towards the camera CAM from the lower layer conductors C, Fig. 1B, and from the base layer L₄. This causes a composite of overlying reflections from the various layers that confusingly makes inspection of the top layer conductors only quite difficult if not impossible in many cases as will later be more fully explained.

The camera and imaging circuitry may be for example of the type described in U.S. Letters Patent Nos. 5,119,434 and 4,697,088 for purposes of image inspection as the multi-layered product chip or other part is passed by the camera or the camera scans over the part. Other optical inspection apparatus are described, as further illustratives, in U.S. Letters Patent Nos. 5,058,982, 5,153,668 and 5,333,052.

In accordance with the present invention, this confusion is admirably obviated through a special use of an incident light L wave length that will cause only the intermediate insulation layer L₂ to fluoresce with light of a greater wavelength than the incident light, as schematically shown by the dotted return rays F in all directions back from the irregular surface of the layer L₂, Fig. 1C, with some fluorescent rays being collimated by the lens L¹ for the camera CAM, including the dotted ray contributions off the vertical axis from exposed bump/depression areas of the layer not covered by the angled conductors. By filtering all rays except those of the fluorescence greater wavelength at the filter FIL, the reflections R of the incident wavelength of Figs. 1A and 1B are suppressed at the filter FIL, only fluorescent light F from the intermediate layer L₂ will be imaged by the camera CAM. With a fluorescing intermediate layer L₂ of thickness sufficient to cause the fluorescing layer to be substantially totally opaqued, this results in showing the top layer pattern of conductors C¹ as dark in the fluorescing light image of the layer L₂, and, because all incident light wavelength reflections R from layers below the intermediate layer L₂ are masked or suppressed, they effectively disappear (shown not passing through filter FIL in Figs. 1A and 1B), affording a dear and selective inspection of just the top pattern of conductors C¹.

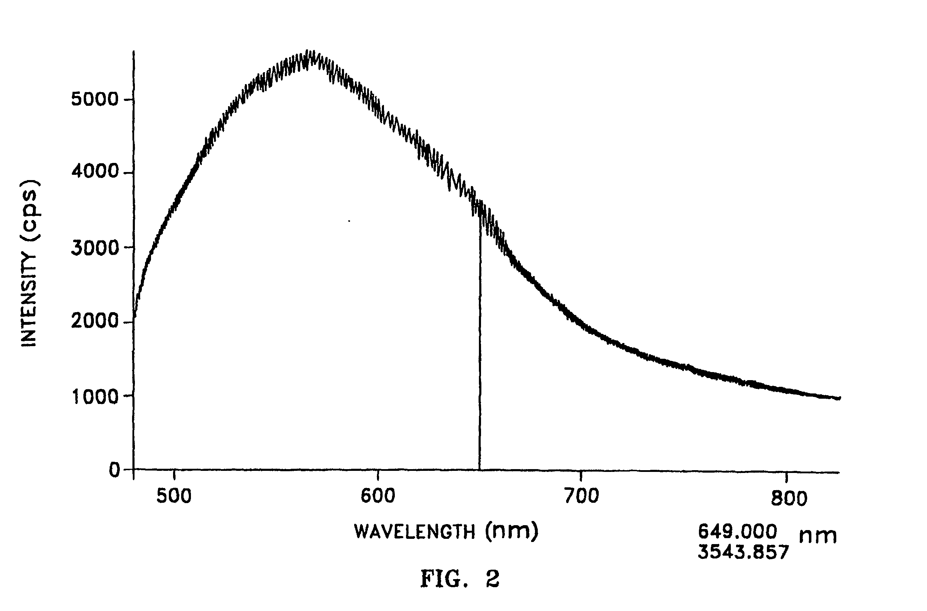

Fig. 2, as before stated, shows the fluorescent light intensity spectrum for a preferred polyimide material of transparent or translucent properties, serving as the intermediate insulation layer L₂ in response to a suitable preferred argon laser light source X.

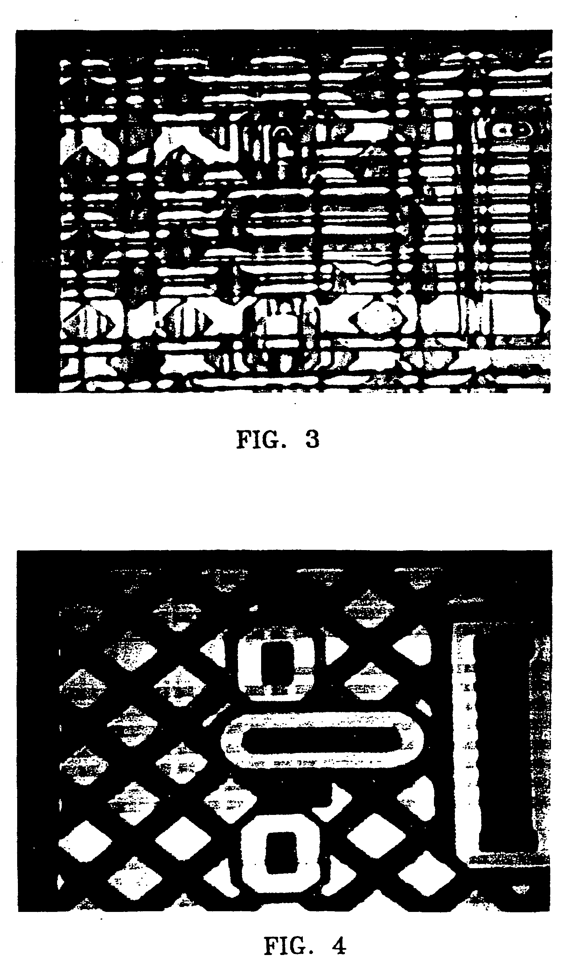

With this, a comparison of Figs. 3 and 4 shows the efficacy of the invention. In Fig. 3, a normal white light image was produced of such a multi-layer wafer circuit, showing all the layers behind the top conductor layer.

In the multi-layered wafer structure shown in Fig. 3, the top layer appears white with many dark lines traversing it, caused by changes in topology, and with all the layers behind being also visible. It is not only very difficult to determine what the top layer is, but it is virtually impossible to find either breaks or shorts or any defect for that matter in the top conductor lines. In contrast, Fig. 4 is a photograph of the fluorescent image obtained in accordance with the invention (Fig. 1C), which clearly shows the top conductors. Variations in the surface of the conductor lines is also apparent. Through this technique the top layer is inspected without interference or overlay by any of the light reflections from the layers therebelow.

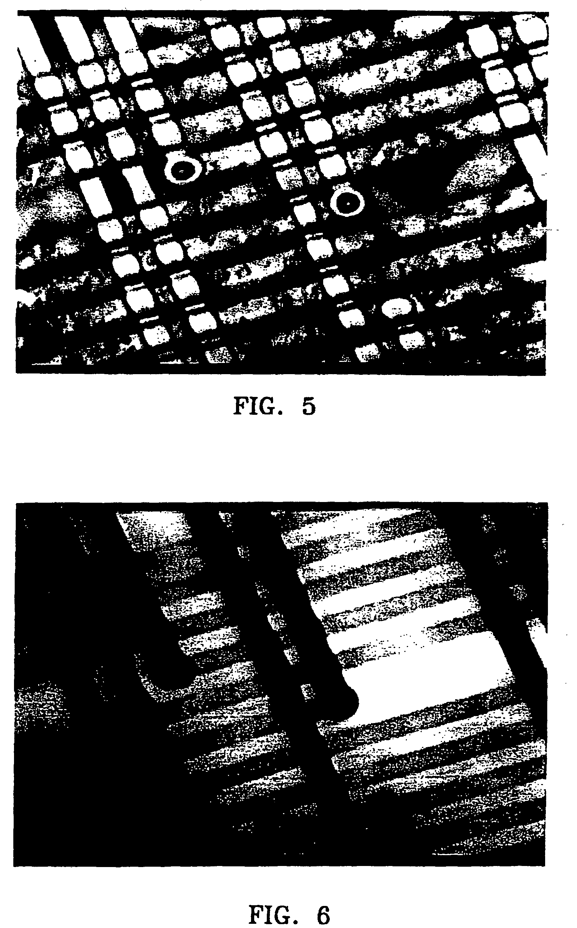

In Fig. 5, another multi-chip module is shown having three layers, where it is difficult to determine what the top layer is, and with many lines and bands running through the image due to topology changes. In Fig. 6, however, using the invention (Fig. 1C), the fluorescent image very clearly distinguishes the top layer conductors to the exclusion of the other, lower layers.

While the invention has thus far been described generally in connection with fluorescing insulation layers, preferred layers are polyimide organics fluorescing in response to 488 (or 514) nanometer incedent argon wavelength illumination. The fluorescence spectrum is in the range of about 500 to 700 nanometers (Fig. 2), and it is in this range that a selective filtering (FIL) is successfully effected to distinguish from any reflections from non-fluorescing materials caused by the incident light as shown in in Figs. 4 and 6. Other wavelength sources and corresponding fluorescing materials as in the above article may also be used in accordance with the phenomenon underlying the invention. Preferred bottom layers or base substrates L₄ are selected from ceramics, glass, epoxys, and metal. The invention, moreover, is applicable wherever there are similar multi-layered electronic or other parts requiring such top layer selectivity of inspection without confusion by reflections from lower layers. These may include, in addition to the wafers from which integrated circuit chips are formed, flat display panels, multi-chip modules, flexible circuit patches and decals and other applications.

Further modifications will also appear to those skilled in this art and all such is considered to fall within the scope or the invention as defined in the appended claims.

## Claims

1. A method for optically inspecting, with the aid of incident light (L) of a predetermined wavelength and an imaging inspection camera (CAM), the top layer (L₁) of a multi-layered electronic part (C) comprising also intermediate (L₂) and bottom (L₄) layers, the top layer (L₁) including a pattern of conductors-to-be-inspected (C¹) covering portions only of an intermediate layer (L₂) of transparent; or translucent insulation of material that fluoresces in response to the incident light (L) at a wavelength different from said predetermined wavelength, so that the pattern of conductors (C¹) exposes some fluorescent areas of the intermediate layer (L₂) to the camera (CAM), and wherein it is desired that the fluorescent wavelength only be received by the camera, the method including filtering out (FIL) the incident light predetermined wavelength, to produce in the camera an image of the pattern of conductors that is contrastingly dark in a background of the fluorescing intermediate layer image, with light reflections from below the intermediate layer effectively disappearing,
**characterised in that** the method is adapted for the inspection of multi-layered parts in which the intermediate layer (L₂) is an irregularly bumpy layer comprising relatively flat regions between a plurality of depressions therein, and the pattern includes conductors (C¹) lying on the intermediate layer which are angled relative to the axis of the incident light (L), the method including collimating (L¹) the filtered light in front of the camera (CAM) to gather in fluorescent rays (F), not only those emitted from the intermediate layer parallel to the axis of the incident light, but also rays emitted along directions not parallel to said axis, whereby the collimating enables the reception of fluorescent ray contributions also from exposed areas of the intermediate layer that have been left uncovered by conductors, thereby to contribute to the fluorescent light received and imaged at the camera, and providing a fluorescent light image that achieves an enhanced contrast of the dark conductor pattern in the image produced by the camera.

2. A method as claimed in claim 1 and in which the intermediate layer (L₂) is provided with via or contact holes which appear dark within the fluorescing image in view of the reflection through the holes from non-fluorescing layer(s) below the intermediate layer.

3. A method as claimed in claim 1 or 2, in which the bottom layer (L₄) is a base substrate selected from the group consisting of ceramic, glass and metal.

4. A method as claimed in any of claims 1 to 3, in which the intermediate layer (L₂) is an organic layer susceptible to fluorescing in response to the incident light wavelength.

5. A method as claimed in claim 4, in which the organic layer comprises a polyimide.

6. A method as claimed in any preceding claim, in which the incident light (L) is provided from an argon source having predetermined emission lines at 488 or 514 nanometers, and the fluorescent wavelength is in the spectrum range of from about 500 to 700 nanometers.

7. A method as claimed in any preceding claim, in which the part (C) is selected from the group consisting of wafers for the forming of integrated circuit chips, flat display panels, multichip modules, and flexible circuit patches and decals.

8. Apparatus for optically inspecting the top layer (L₁) of a multi-layered electronic part (C) comprising also intermediate (L₂) and bottom (L₁) layers, the top layer (L₁) including a pattern of conductors-to-be-inspected (C¹) disposed upon an intermediate layer (L₂) of transparent or translucent insulation and covering only portions thereof, said apparatus having, in combination, an incident light source of predetermined wavelength to which the intermediate insulation layer (L₂), and not the conductors (C¹) and other layers, responds by fluorescing at a different wavelength; an optical path for directing the incident light (L) upon the top layer (L₁) to cause reflection (R) of the incident light back towards an inspection camera (CAM) for imaging the top layer therein, and means (FIL) for filtering out the reflected light'of said predetermined wavelength to prevent its receipt by the camera, so that an image will be produced in the camera of a non- fluorescing pattern of conductors as contrasting dark images in a background of the fluorescing intermediate layer image, with light reflections from below the intermediate layer effectively disappearing,
**characterised in that** the apparatus is adapted for the inspection of multi-layered parts (C) in which the intermediate layer (L₂) has irregularly spaced and shaped bumps, and the pattern includes conductors (C¹) lying on the intermediate layer which are angled relative to the axis of the incident light (L), the apparatus including a collimating lens (L¹) in front of the camera (CAM) to gather in fluorescent rays (F), not only those emitted from the intermediate layer parallel to the axis of the incident light, but also rays emitted along directions not parallel to said axis, whereby the collimating lens (L¹) enables the reception of fluorescent ray contributions also from exposed areas of the bumps that have been left uncovered by conductors (C¹), thereby to contribute to the fluorescent light received and imaged at the camera (CAM), and providing a fluorescent light image that achieves an enhanced contrast of the dark conductor pattern in the image produced by the camera.

## Revendications

1. Procédé pour inspecter optiquement, avec l'aide de la lumière incidente (L) d'une longueur d'onde prédéterminée et d'une caméra d'imagerie d'inspection (CAM), la couche supérieure (L₁) d'une pièce électronique à couches multiples (C) comprenant également des couches intermédiaire (L₂) et inférieure (L₄), la couche supérieure (L₁) comprenant un masque de conducteurs à inspecter (C¹) recouvrant uniquement les parties d'une couche intermédiaire (L₂) d'un matériau d'isolation transparent ou translucide qui émet un rayonnement fluorescent en réponse à la lumière incidente (L) d'une longueur d'onde différente de la longueur d'onde prédéterminée, de sorte que le masque de conducteurs (C¹) expose certaines zones fluorescentes de la couche intermédiaire (L₂) à la caméra (CAM), et dans lequel il est souhaité que la longueur d'onde fluorescente soit perçue uniquement par la caméra, le procédé comprenant le filtrage (FIL) de la longueur d'onde prédéterminée de la lumière incidente, pour produire dans la caméra une image du masque de conducteurs qui est sombre de façon contrastée dans un arrière-plan de l'image de la couche intermédiaire fluorescente, avec les réflexions de lumière issues des couches inférieures à la couche intermédiaire disparaissant de façon efficace,
**caractérisé en ce que** le procédé est adapté à l'inspection des pièces à couches multiples, dans lesquelles la couche intermédiaire (L₂) est une couche bosselée de façon irrégulière comprenant des régions relativement plates entre une pluralité de dépressions, et le masque comprend des conducteurs (C¹) se trouvant sur la couche intermédiaire qui forment un angle aigu avec l'axe de la lumière incidente (L), le procédé comprenant la collimation (L¹) de la lumière filtrée devant la caméra (CAM) pour rassembler les rayons fluorescents (F), non seulement ceux émis par la couche intermédiaire parallèlement à l'axe de la lumière incidente, mais également les rayons émis le long de directions non parallèles à l'axe de la lumière incidente, moyennant quoi la collimation permet la réception des contributions de rayons fluorescents également issus de zones exposées de la couche intermédiaire qui ont été laissées non couvertes par les conducteurs, pour contribuer ainsi à la lumière fluorescente reçue et imagée par la caméra, et fournissant une image de lumière fluorescente qui réalise un contraste amélioré du masque de conducteur sombre dans l'image produite par la caméra.

2. Procédé selon la revendication 1 dans lequel la couche intermédiaire (L₂) est pourvue d'orifices de contact ou de raccordement qui apparaissent sombres à l'intérieur de l'image fluorescente au vu de la réflexion à travers les orifices issus de la (des) couche (s) fluorescente (s) inférieures à la couche intermédiaire.

3. Procédé selon la revendication 1 ou 2, dans lequel la couche inférieure (L₄) est un substrat de base choisi dans un groupe composé par la céramique, le verre et le métal.

4. Procédé selon l'une quelconque des revendications 1 à 3, dans lequel la couche intermédiaire (L₂) est une couche organique susceptible d'émettre un rayonnement de fluorescence en réponse à la longueur d'onde de la lumière incidente.

5. Procédé selon la revendication 4, dans lequel la couche organique comprend un polyimide.

6. Procédé selon l'une quelconque des revendications précédentes, dans lequel la lumière incidente (L) est issue d'une source d'argon ayant des raies d'émission prédéterminées à 488 ou 514 nanomètres, et la longueur d'onde fluorescente est dans la gamme de spectre comprise entre 500 et 700 nanomètres environ.

7. Procédé selon l'une quelconque des revendications précédentes, dans lequel la pièce (C) est choisie dans le groupe de wafers pour la formation de puces de circuit intégré, de panneaux d'affichage plats, de modules à puces multiples, et des plages de circuit flexibles et de décalcomanies.

8. Dispositif pour inspecter optiquement la couche supérieure (L₁) d'une pièce électronique à couches multiples (C) comprenant également des couches intermédiaire (L₂) et inférieure (L₄), la couche supérieure (L₁) comprenant un masque de conducteurs à inspecter (C¹) disposés sur une couche intermédiaire (L₂) d'isolation transparente ou translucide et recouvrant uniquement des parties de celle-ci, ledit dispositif ayant, en combinaison, une source de lumière incidente d'une longueur d'onde prédéterminée à laquelle la couche d'isolation intermédiaire (L₂), et non les conducteurs (C¹) et d'autres couches, répond en émettant un rayonnement fluorescent à une longueur d'onde différente ; un chemin optique pour diriger la lumière incidente (L) sur la couche supérieure (L₁) pour provoquer la réflexion (R) de la lumière incidente vers une caméra d'inspection (CAM) pour imager la couche supérieure, et un moyen (FIL) pour filtrer la lumière réfléchie de la longueur d'onde prédéterminée pour empêcher la réception de celle-ci par la caméra, pour qu'une image soit produite dans la caméra d'un masque non fluorescent de conducteurs comme des images sombres de contraste dans un arrière-plan de l'image de la couche intermédiaire fluorescente, avec des réflexions de lumière issues des couches inférieures à la couche intermédiaire disparaissant de façon efficace,
**caractérisé en ce que** le dispositif est adapté pour l'inspection des pièces à couches multiples (C), dans lequel la couche intermédiaire (L₂) a des bosses espacées de façon irrégulière et de formes diverses, et le masque comprend des conducteurs (C¹) se trouvant sur la couche intermédiaire qui forment un angle aigu avec l'axe de la lumière incidente (L), le dispositif comprenant une lentille de collimation (L¹) devant la caméra (CAM) pour rassembler les rayons fluorescents (F), non seulement ceux émis par la couche intermédiaire parallèle à l'axe de la lumière incidente, mais également les rayons émis le long des directions non parallèles audit axe, moyennant quoi la lentille de collimation permet la réception des contributions de rayons fluorescents également à partir de zones exposées des bosses qui ont été laissées non couvertes par les conducteurs (C¹), pour contribuer ainsi à la lumière fluorescente reçue et imagée par la caméra (CAM), et fournissant une image de lumière fluorescente qui réalise un contraste amélioré du masque de conducteur sombre dans l'image produite par la caméra.

## Patentansprüche

1. Verfahren zum optischen Prüfen, unter Zuhilfenahme von Auflicht (L), einer vorbestimmten Wellenlänge und einer bildliefernden Prüfkamera (CAM), der Deckschicht (L₁) eines mehrschichtigen elektronischen Bauteils (C), dass auch Zwischen- (L₂) und Basisschichten (L₄) aufweist, wobei die Deckschicht (L₁) eine Struktur von zu prüfenden Leiterbahnen (C¹) enthält, die nur Bereiche einer Zwischenschicht (L₂) einer transparenten oder lichtdurchlässigen Isolierung aus einem Material, das als Reaktion auf das Auflicht (L) in einer von der vorbestimmten Wellenlänge verschiedenen Wellenlänge fluoresziert, verdeckt, so dass die Struktur von Leiterbahnen (C¹) der Kamera (CAM) einige fluoreszierende Bereiche der Zwischenschicht (L₂) freilegt und wobei verlangt wird, dass nur die fluoreszierende Wellenlänge von der Kamera empfangen wird, das Verfahren das Ausfiltern (FIL) des Auflichts der vorbestimmten Wellenlänge beinhaltet, um in der Kamera ein Bild der Struktur der Leiterbahnen, die kontrastierend dunkel auf einem Hintergrund des fluoreszierenden Bildes der Zwischenschicht ist, wobei Lichtreflektionen von unterhalb der Zwischenschicht wirkungsvoll verschwinden, zu erzeugen,
**dadurch gekennzeichnet, dass** das Verfahren zum Prüfen mehrschichtiger Bauteile, in denen die Zwischenschicht (L₂) eine unregelmäßig unebene Schicht ist, die relativ flache Bereiche zwischen einer Vielzahl von Senken darin aufweist und die Struktur auf der Zwischenschicht liegende Leiterbahnen (C¹) beinhaltet, die relativ zur Achse des Auflichts (L) abgewinkelt sind, angepasst ist, das Verfahren das Bündeln (L¹) des gefilterten Lichts vor der Kamera (CAM) beinhaltet, um die fluoreszierenden Strahlen (F) zu sammeln, nicht nur die, die von der Zwischenschicht parallel zur Achse des Auflichts ausgesandt werden, sondern auch die Strahlen, die in Richtungen ausgesandt werden, die nicht parallel zu besagter Achse sind, wobei das Bündeln auch die Aufnahme von fluoreszierenden Strahlenanteilen von freiliegenden Bereichen der Zwischenschicht, die von den Leiterbahnen nicht verdeckt worden sind, ermöglicht, um es dadurch zu dem Licht hinzuzufügen, das von der Kamera empfangen und dargestellt wird und ein fluoreszierendes helles Bild bzw. ein Fluoreszenzlichtbild liefert, das einen verbesserten Kontrast zu der dunklen Struktur der Leiterbahnen in dem von der Kamera erzeugten Bild aufweist.

2. Ein Verfahren wie in Anspruch 1 beansprucht und in dem die Zwischenschicht (L₂) mit Durchgangs- oder Kontaktlöchern ausgestattet ist, die dunkel erscheinen in dem fluoreszierenden Bild angesichts der Reflektion durch die Löcher einer nicht fluoreszierenden Schicht bzw. nicht fluoreszierenden Schichten unter der Zwischenschicht.

3. Ein Verfahren wie es in den Ansprüchen 1 oder 2 beansprucht ist, in welchem die Basisschicht (L₄) ein Basissubstrat, ausgewählt aus der Gruppe, die Keramik, Glas und Metall, enthält, ist.

4. Ein Verfahren wie es in einem der Ansprüche 1 bis 3 beansprucht ist, in welchem die Zwischenschicht (L₂) eine organische Schicht ist, die das Fluoreszieren als Reaktion auf die Wellenlänge des Auflichts zulässt.

5. Ein Verfahren wie es in Anspruch 4 beansprucht ist, in welchem die organische Schicht ein Polyimid aufweist.

6. Ein Verfahren wie es in einem der vorangehenden Ansprüche beansprucht ist, in welchem das Auflicht (L) von einer Argonquelle bereitgestellt wird, die vorbestimmte Emissionslinien bei 488 oder 514 Nanometern besitzt und die fluoreszierende Wellenlänge in dem Spektralbereich von ungefähr 500 bis 700 Nanometern liegt.

7. Ein Verfahren, wie es in einem der vorangehenden Ansprüche beansprucht ist, in welchem das Bauteil (C) aus der Gruppe, die aus Halbleiterscheiben bzw. Wafern zum Gestalten von integrierten Schaltungschips, flachen Anzeigefeldem, Multichipmodulen und flexiblen Schaltungs- bzw. Schalterflächen und Aufklebetiketten bzw. Schaltungsaufklebetiketten besteht, ausgewählt ist.

8. Vorrichtung zum optischen Prüfen der Deckschicht (L₁) eines mehrschichtigen elektronischen Bauteils (C), dass auch Zwischen- (L₂) und Basisschichten (L₁) aufweist, wobei die Deckschicht (L₁) eine Struktur von zu prüfenden Leiterbahnen (C¹) enthält, die auf einer Zwischenschicht (L₂) aus einer durchsichtigen oder lichtdurchlässigen Isolierung aufgelegt ist und nur Teile von dieser verdeckt, wobei die Vorrichtung in Kombination, eine Auflichtquelle einer vorbestimmten Wellenlänge, auf das nur die isolierende Zwischenschicht (L₂) und nicht die Leiterbahnen (C¹) und andere Schichten durch Fluoreszieren mit einer anderen Wellenlänge reagieren, einen Strahlengang zum Führen des Auflichts (L) auf die Deckschicht (L₁) um eine Reflektion (R) des Auflichts zurück zur Prüfkamera (CAM) hervorzurufen, um in ihr die Deckschicht darzustellen und Mittel (FIL) zum Ausfiltern des reflektierten Lichts der vorbestimmten Wellenlänge, um dessen Aufnahme durch die Kamera zu verhindern, so dass in der Kamera ein Bild eines nicht fluoreszierenden Musters von Leiterbahnen als kontrastierende dunkle Abbildungen auf einem Hintergrund des fluoreszierenden Bildes der Zwischenschicht erzeugt wird, wobei Lichtreflektionen von unterhalb der Zwischenschicht wirkungsvoll verschwinden, aufweist,
**dadurch gekennzeichnet, dass** die Vorrichtung zum Prüfen von mehrschichtigen Bauteilen (C) angepasst ist, in welchen die Zwischenschicht (L₂) unregelmäßig beabstandete und geformte Unebenheiten aufweist und die Struktur Leiterbahnen (C¹) beinhaltet, die auf der Zwischenschicht liegen und relativ zur Achse des Auflichts (L) abgewinkelt sind, die Vorrichtung eine Fokussierlinse (L¹) vor der Kamera (CAM) beinhaltet, um die fluoreszierenden Strahlen (F) zu sammeln, nicht nur die, die von der Zwischenschicht parallel zur Achse des Auflichts ausgesandt werden, sondem auch die Strahlen, die in Richtungen emittiert werden, die nicht parallel zu dieser Achse sind, wobei die Fokussierlinse (L¹) den Empfang von fluoreszierenden Strahlenanteilen auch von freigelegten Bereichen der Unebenheiten, die durch die Leiterbahnen (C¹) unverdeckt gelassen worden sind, ermöglicht, es dabei dem fluoreszierenden Licht hinzufügt, das von der Kamera (CAM) empfangen und dargestellt wird und ein fluoreszierendes helles Bild bzw. Fluoreszenzlichtbild liefert, das einen verbesserten Kontrast zu der dunklen Struktur der Leiterbahnen in dem von der Kamera erzeugten Bild aufweist.
